# EUROPEAN PATENT SPECIFICATION

(11) **EP 4 327 354 B1**
(45) Date of publication and mention of the grant of the patent: **25.09.2024**
(21) Application number: 22750787.8
(22) Date of filing: 11.07.2022
(51) Int. Cl.: H01L 29/78, H01L 21/336, H01L 29/08

(54) **POWER SEMICONDUCTOR DEVICE AND METHOD FOR PRODUCING A POWER SEMICONDUCTOR DEVICE**
LEISTUNGSHALBLEITERBAUELEMENT UND VERFAHREN ZUR HERSTELLUNG EINES LEISTUNGSHALBLEITERBAUELEMENTS
DISPOSITIF À SEMI-CONDUCTEUR DE PUISSANCE ET SON PROCÉDÉ DE PRODUCTION

(43) Date of publication of application: 28.02.2024
(73) Proprietor: Hitachi Energy Ltd, 8050 Zürich (CH)
(72) Inventor: WIRTHS, Stephan, 8800 Thalwil (CH); KNOLL, Lars, 5607 Hägglingen (CH)
(74) Representative: Epping - Hermann - Fischer
(86) International application number: PCT/EP2022/069273
(87) International publication number: WO 2024/012648

(56) References cited:
- US-A- 5 907 169
- US-A1- 2012 112 266
- US-A1- 2018 019 129
- US-A1- 2018 097 063

## Description

The present disclosure relates to a power semiconductor device and a method for producing a power semiconductor device.

Document US 2012/112266 A1 relates to a semiconductor device and a method for manufacturing the semiconductor device, and particularly to a reduction in a field and in a gate capacitance of a gate insulating film in a JFET region of a MOSFET.

Document US 5 907 169 A8 relates to the structure and fabrication process of semiconductor transistors and, particularly, to a structure and manufacture process for a high density shallow junction semiconductor power device which has improved punch through prevention characteristics, maintaining a low JFET resistance, achieving higher switching speed while manufactured with a process flow without requiring the use of a polysilicon mask.

Document US 2018/019129 A1 discloses a vertical semiconductor device based on a group-III nitride semiconductor and corresponding manufacturing method, wherein the source semiconductor region is formed on the top surface of the device in contact with the underlying base region.

There is a need for an improved power semiconductor device, for example with good contact resistance and/or reduced parasitic capacitances. Furthermore, there is a need for an improved method for producing such a power semiconductor device.

Embodiments of the disclosure relate to an improved power semiconductor device. Other embodiments relate to an improved method for producing a power semiconductor device.

Firstly, the power semiconductor device is specified. The power semiconductor device is, for example, configured to process a current of at least 1 A and/or voltages of at least 100 V. The power semiconductor device is, for example, a socalled vertical power semiconductor device.

According to an embodiment, the power semiconductor device comprises a semiconductor body with a top side, a main electrode on the top side and a gate electrode on the top of a base region and arranged next to the main electrode in a first lateral direction. The semiconductor body comprises a drift layer of a first conductivity type, the base region of a second conductivity type arranged vertically between the drift layer and the top side, a contact region of the first conductivity type at the top side arranged vertically between the drift layer and the top side. The contact region adjoins the base region wicte. Furthermore, the semiconductor body comprises a drift region of the first conductivity type arranged next to the base region in the first lateral direction and adjoining the base region. The main electrode is in electrical contact with the top of the contact region. In plan view of the top side, the gate electrode at least partially covers a channel portion of the base region which lies, in the first lateral direction, between the contact region and the drift region. At the top side, the contact region projects beyond the top of the base region in vertical direction.

Nowadays most commercially available power semiconductor devices are based on cell designs with planar channels aligned to the top side of the semiconductor body. However, the boost of current densities in such devices is hampered due to the parasitic junction-FET (parasitic JFET) below the gate electrode and due to the contact resistance increase with down-scaling. Additionally, the parasitic gate/drain capacitance, Cgd, which is strongly related to the parasitic JFET significantly increases with reduced pitch dimensions. Although the trench design originally promised to reduce or even eliminate the parasitic JFET, current trench power semiconductor devices indeed still rely on it.

The device concept proposed herein is based, inter alia, on the idea of using a raised source and/or drift region. This allows the contact resistances to be significantly reduced and the parasitic gate/drain capacitance Cgd to be eliminated. This in turn results in unrivalled switching performance and enables significant chip size reduction.

The semiconductor body is, for example, based on Si, SiC or GaN. The main electrode on the top side is, for example, a metal electrode. The gate electrode may be made of metal or a highly doped polysilicon. The gate electrode is, for example, electrically isolated from the semiconductor body by an electrically isolating material, like SiO₂. Thus, the power semiconductor device may be an insulated gate device. Particularly, the gate electrode and the main electrode are electrically isolated from each other so that they can be set to different electrical potentials for operation.

The gate electrode is arranged next to or adjacent to the main electrode in the first lateral direction. A lateral direction is herein, for example, a direction parallel to a main extension plane of the semiconductor body. Accordingly, the vertical direction is defined as a direction perpendicular to the main extension plane of the semiconductor body.

The drift layer is of a first conductivity type. The first conductivity type can be either electron conduction or hole conduction. The second conductivity type is different from the first conductivity type, i.e. is either hole conduction or electron conduction. A region or layer being of electron conduction is n-doped and a region or layer being of hole conduction is p-doped. For example, the doping concentration in the first drift layer is at least 10⁸ cm⁻³ and at most 10¹⁵ cm⁻³.

The base region is arranged vertically between the drift layer and the top side, i.e. is arranged between the top side and the drift layer in vertical direction. For example, the base region adjoins the drift layer and/or the top side. For example, the doping concentration in the base region is greater than in the drift layer, e.g. at least 10 times or at least 100 times greater. For example, the doping concentration in the base region is at least 10¹⁵ cm⁻³ and/or at most 10¹⁸ cm⁻³.

Herein, when comparing doping concentrations of layers or regions, the average doping concentrations or maximum doping concentrations of these layers or regions are compared. When defining upper and lower limits of the doping concentration in a layer or region, it is meant that the maximum doping concentration in the respective layer/region does not exceed the upper limit and the minimum doping concentration in the respective layer/region does not fall below the lower limit. The regions mentioned herein are, for example, each contiguous regions, particularly without holes or interruptions.

The contact region is of the same conductivity type as the drift region. For example, the doping concentration of the contact region is greater than the doping concentration of the drift layer and/or the base region, e.g. at least 10 times or at least 100 times greater. By way of example, the doping concentration in the contact region is at least 10¹⁷ cm⁻³ or at least 10¹⁸ cm⁻³ or at least 10¹⁹ cm⁻³.

The contact region adjoins the base region and the top side, i.e. forms part of the top side. The contact region may adjoin the base region in vertical and/or lateral direction, particularly in the first lateral direction. For example, the contact region is partially or completely laterally surrounded by the base region. The contact region is embedded in the base region.

The drift region is of the same conductivity type as the contact region and the drift layer. For example, the doping concentration in the drift region is smaller than in the contact region, e.g. at least 10 times or at least 100 times smaller. The doping concentration in the drift region may, however, be greater than in the drift layer, e.g. at least 10 times or at least 100 times greater. For example, the doping concentration in the drift region is at least 10¹⁵ cm⁻³ and/or at most 10¹⁸ cm⁻³. The drift region is also known as JFET region.

The drift region is arranged next to the base region in the first lateral direction and adjoins the base region in the first lateral direction. The drift region is spaced from the contact region in the first lateral direction by a portion of the base region, this portion is herein called "channel portion". The drift region and/or the channel portion may adjoin the top side of the semiconductor body, i.e. form part of the top side.

The main electrode is in electrical contact, i.e. direct electrical contact, with the contact region. The main electrode may adjoin the contact region at the top side. Electrical contact herein means ohmic electrical contact, for example.

The gate electrode is arranged laterally next to the main electrode and is aligned with the channel portion of the base region in the first lateral direction. Thus, in plan view of the top side, the gate electrode partially or completely covers or overlaps, respectively, the channel portion. The gate electrode may also overlap a portion of the contact region and/or of the drift region in this plan view. However, the gate electrode may be electrically isolated from the channel portion, the contact region and the base region by the electrically isolating material.

The semiconductor body may comprise several drift regions, base regions and corresponding contact regions. All features disclosed in connection with one drift region, one base region and one contact region are also disclosed for all other drift regions, base regions and contact regions. For example, a drift region is arranged between each pair of base regions in the first lateral direction. Moreover, each channel portion of a base regions is assigned a gate electrode overlapping with said channel portion in plan view of the top side.

The channel portion is a portion through which charge carries flow from the contact region into the drift region during operation. For example, the power semiconductor device is configured to deplete the channel portion at the side facing the gate electrode with the help of the gate electrode and thereby to enable a current flow from the main electrode, through the contact region, via the depleted channel portion and into the drift region.

At the top side, at least one of the contact region and the drift region projects beyond the base region in vertical direction. For example, the contact region and/or the drift region project beyond the base region by at least 50 nm or at least 100 nm and/or at most 1 um or at most 5 um. In other words, the contact region and/or the drift region terminate at a greater height with respect to the drift layer than the base region. For example, both the contact region and the drift region project beyond the base region in vertical direction at the top side. The projecting contact region and/or drift region may taper in vertical direction away from the drift layer.

With a raised contact region, the contact resistance can be reduced. The raised drift region allows, for example, Cgd to be reduced.

According to a further embodiment, at least one of the contact region and the drift region is grown epitaxially. For example, both the contact region and the drift region are grown epitaxially. The contact region and/or the drift region may be grown on a base semiconductor body comprising the drift layer. The drift layer and/or the base region may be formed by implantation of dopants.

According to at least one embodiment, at least one the epitaxially grown regions, i.e. the contact region and/or the drift region, has an inverted doping profile, e.g. over its whole volume, with a doping concentration decreasing in (along) a direction pointing from the interior of the semiconductor body towards the top side. Additionally or alternatively, at least one of the epitaxially grown regions has a homogenous doping profile, e.g. over its whole volume. It is possible that both regions have an inverted doping profile or a homogenous doping profile. It is also possible that the epitaxially grown contact region has a homogenous doping profile and the epitaxially grown drift region has an inverted doping profile or vice versa.

An epitaxially grown region with an inverted doping profile has, for example, a minimum doping concentration which is at least one order or at least two orders of magnitude lower than a maximum doping concentration in said region. An epitaxially grown region with a homogeneous doping profile has, for example, a maximum deviation from the average doping concentration of at most 20 % or at most 10 %

It is also possible that at least one of the epitaxially grown regions has a doping profile with the doping concentration decreasing in (along) a direction pointing from the top side towards the interior of the semiconductor body. The difference in the maximum and minimum doping concentration may be the same as for the inverted doping profile.

Growing the contact region and/or the drift region epitaxially not only allows these regions to be formed to project beyond the base region but also enables the doping concentrations of these regions to be individually and independently set. Moreover, the doping concentrations of these regions can be set greater than when these regions are formed with implantation, for example. Furthermore, the doping concentrations of these regions can be made very homogeneously over the whole volume of the regions or with special doping profiles, like inverted doping profiles.

According to a further embodiment, at the top side, the drift region projects beyond the base region in vertical direction. In plan view of the top side, the gate electrode covers at most a portion of the drift region. For example, in plan view of the top side, the gate electrode covers at most 50 % or at most 25 % of the drift region. By way of example, the gate electrode does not cover the drift region at all, e.g. it is spaced from the drift region in the first lateral direction or terminates flush with the drift region in the first lateral direction.

The raised/projecting drift region enables the gate electrode to be formed such that it does not completely overlap with the drift region. In this way, Cgc can be significantly reduced.

According to a further embodiment, the contact region and the channel portion are at least partially aligned in the vertical direction. For example, when viewed along the first lateral direction, the contact region and the channel portion at least partially overlap with each other. For example, the contact region and the channel portion completely overlap with each other in this view. The alignment in vertical direction enables an efficient injection of charge carriers from the contact region into the channel portion.

Starting from the top side, the base region projects deeper into the semiconductor body than the contact region. A portion of the base region may be arranged vertically between the contact region and the drift layer. In other words, the distance between the contact portion and a back side of the semiconductor body is smaller than the distance between the base region and the back side. The back side is the side of the semiconductor body opposite to the top side.

According to a further embodiment, the doping concentration in the drift region is greater than in the drift layer, e.g. at least 10 times or at least 100 times greater.

According to a further embodiment, in plan view of the top side, the gate electrode partially covers the contact region and/or the drift region. The gate electrode may have a first section which tapers towards the top side, i.e. the lateral extension in the first lateral direction decreases in the direction towards the top side. This first section may overlap with the contact region and/or the drift region in plan view. The tapering is, for example, a consequence of the production process.

The gate electrode may also have a second section which tapers in the direction away from the top side. The first section may be arranged vertically between the top side and the second section.

According to a further embodiment, the power semiconductor device is a MOSFET or an IGBT or a JFET or a MISFET or a thyristor.

According to a further embodiment, the semiconductor body is based on a wide-bandgap semiconductor, like SiC or GaN.

According to a further embodiment, the gate electrode and at least one of the contact region and the drift region projecting beyond the base region are at least partially aligned in the vertical direction. For example, when viewed along the first lateral direction, the gate electrode and the projecting contact region and/or the projecting drift region at least partially overlap with each other.

Next, the method for producing a power semiconductor device is specified. The method may, in particular, be used for producing the power semiconductor device according to any of the embodiments described herein. Therefore, all features disclosed for the power semiconductor device are also disclosed for the method and vice versa.

According to an embodiment, the method comprises a step of producing a semiconductor body with a top side such that the semiconductor body has a drift layer of a first conductivity type, a base region of a second conductivity type arranged vertically between the drift layer and the top side, a contact region of the first conductivity type arranged vertically between the drift layer and the top side and adjoining the base region and being located at the top side, and a drift region of the first conductivity type arranged next to the base region in a first lateral direction and adjoining the base region. In a further step, a main electrode is applied onto the top side and an electrical contact between the main electrode and the contact region is established. In a further step, a gate electrode is produced so that, in the end, the gate electrode is arranged on the top of the base region and next to the main electrode in the first lateral direction and so that, in plan view of the top side, the gate electrode at least partially overlaps a channel portion of the base region which lies, in the first lateral direction, between the contact region and the drift region. The semiconductor body is produced such that, at the top side, the contact region projects beyond the top of the base region in vertical direction.

The gate electrode may be produced before or after applying the main electrode. Moreover, the gate electrode may be produced before or after forming the raised, i.e. projecting, contact region and/or drift region.

According to a further embodiment, the production of the semiconductor body comprises the step of providing a base semiconductor body having the drift layer and the base region. Before that, the base region and/or the drift layer may be formed in the base semiconductor body by means of implantation of dopants. The base semiconductor body may be based on a wide-bandgap semiconductor, like SiC or GaN.

According to a further embodiment, the production of the semiconductor body comprises a step of epitaxially growing at least one of the contact region and the drift region on the base semiconductor body.

According to at least one embodiment, the epitaxial growing is done by Chemical Vapor Deposition (CVD).

For example, at least one of the following precursors is used for the epitaxial growth: Monosilane, Disilane, Trisilane, chlorinated precursor, like DCS (Dichlorsilane), carbon precursor, like methane.

For example, at least one of the following doping precursors is used for doping during the epitaxial growth: Diborane or Phosphine.

According to at least one embodiment, the doping profile of the epitaxially grown region is set by adjusting the mass flow of the doping precursor. For example, an inverted doping profile is created by reducing the mass flow of the doping precursor during the epitaxial growth.

According to a further embodiment, before growing the contact region, a portion of the base semiconductor is removed in the area where the contact region is to be formed. The contact region is then grown in that area.

For example, a hole is etched into the base semiconductor body for defining the area for the growth of the contact region. The depth of the hole, measured in vertical direction, is, for example, at least 1 µm or at least 2 um. For example, the hole is etched such that it completely extends through the base region in the vertical direction. Alternatively, the hole may be etched with such a depth that it opens into the base region.

According to a further embodiment, before growing the drift region, a portion of the base semiconductor body is removed in the area where the drift region is to be formed. The drift region is then grown in that area.

For example, a hole is etched into the base semiconductor body for defining the area for the growth of the drift region. The depth of the hole, measured in vertical direction, is, for example, at least 1 µm or at least 2 um.

According to a further embodiment, the gate electrode is formed on the base semiconductor body. For example, this is done after the formation of the base region and/or the drift layer. The gate electrode may be formed before at least one of the drift region and the contact region is produced, for example by means of epitaxial growth.

For forming the gate electrode, a gate electrode layer may first be applied onto the top side of the base semiconductor body. The gate electrode layer may thereby be electrically isolated from the top side by a layer of an electrically isolating material arranged between the gate electrode layer and the top side.

In a further step, the gate electrode layer and the electrically isolating layer below it may be structured in order to form the gate electrode. Thereby, portions of the gate electrode layer and the underlying isolating layer may be removed, e.g. by means of etching. For structuring the gate electrode layer and the electrically isolating layer, a mask may be used.

According to a further embodiment, an electrically isolating material is applied at least on lateral surfaces of the gate electrode. The lateral surfaces are surfaces delimiting the gate electrode in lateral direction, particularly in the first lateral direction. The lateral surfaces run obliquely or perpendicularly to the main extension plane of the (base) semiconductor body.

The electrically isolating material may be deposited onto the gate electrode by means of an undirected or conformal deposition method, respectively.

According to a further embodiment, at least one of the contact region and the drift region is selectively grown adjacent to the gate electrode with the applied isolating material thereon. That is, the gate electrode with the applied isolating material is used as a mask for a selective growth process. For example, the contact region is grown on one side of the gate electrode and the drift region is grown on the other side of the gate electrode, wherein "side" and "other side" are meant with respect to the first lateral direction.

For example, when growing the contact region and/or the drift region, the respective region is grown such that it adjoins the electrically isolating material in the first lateral direction.

Hereinafter, the power semiconductor device and the method for producing a power semiconductor will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figures 1 to 4 show exemplary embodiments of the power semiconductor device,
Figure 5 shows a flowchart of an exemplary embodiment of the method for producing a power semiconductor device and
Figure 6 to 12 show different positions in an exemplary embodiment of the method for producing a power semiconductor device.

The first exemplary embodiment of the power semiconductor device 100 according to figure 1 comprises a semiconductor body 1 which is, for example, based on a wide-bandgap material, like 6H-SiC or 3C-SiC. A main electrode 2 and two gate electrodes 3 are arranged on a top side 10 of the semiconductor body 1.

The semiconductor body 1 comprises a drift layer 11 being of a first conductivity type. In the following, the first conductivity type is assumed to be electron conduction or n-conduction, respectively. Hence, the drift layer 11 is n-doped. The second conductivity type is hole conduction or p-conduction respectively and, therefore, the corresponding doping is p-type doping. However, the whole concept also works when the different regions or layers have the opposite type of doping. For example, the doping concentration in the drift layer 11 is in the range of 10⁸ cm⁻³ to 10¹⁵ cm⁻³.

On a bottom side of the drift layer 11, a substrate 15, namely a SiC substrate 15, is arranged which adjoins the drift layer 11. The substrate 15 is also of the first conductivity type, i.e. n-doped in the present case. For example, the doping concentration is in the same range as for the drift layer 11. In vertical direction V, which is perpendicular to a main extension plane of the semiconductor body 1, the substrate 15 is arranged between a further main electrode 6 and the drift layer 11. The further main electrode 6 adjoins the substrate 15 and is in electrical contact with the substrate 15. For example, the further main electrode is made of metal.

The semiconductor body 1 comprises two base regions 12 which are spaced from each other in a first lateral direction L1, said first lateral direction L1 being parallel to the main extension plane of the semiconductor body 1. The semiconductor body 1 further comprises a drift region 14 which is arranged between the two base regions 12 in the first lateral direction L1. The base regions 12 are of the second conductivity type, i.e. are p-doped, and the drift region 14 is of the first conductivity type, i.e. n-doped. The base regions 12 adjoin the drift region 14 in the first lateral direction L1. The base regions 12 and the drift region 14 are arranged between the drift layer 11 and the top side 10 of the semiconductor body 1 in the vertical direction V. Thereby, the drift region 14 and the base regions 12 adjoin the top side 10 as well as the drift layer 11 in vertical direction V.

By way of example, the base regions 12 each have a doping concentration in the range between 10¹⁵ cm⁻³ and 10¹⁸ cm⁻³. The doping concentration of the drift region 14 may be greater than that of the drift layer 11, e.g. may be in the range between 10¹⁵ cm⁻³ and 10¹⁸ cm⁻³.

The semiconductor body 1 further comprises two contact regions 13, wherein each contact region 13 is assigned to a base region 12. The contact regions 13 are of the first conductivity type and each adjoin the assigned base region 12 as well as the top side 10 of the semiconductor body 1. In the exemplary embodiment of figure 1, the contact regions 13 adjoin the assigned base regions 12 in vertical direction V as well as in the first lateral direction L1. The doping concentration of the first contact regions 13 is, for example, in each case at least 10¹⁹ cm⁻³.

In the exemplary embodiment of figure 1, the contact regions 13 and the drift region 14 project beyond the base regions 12 in vertical direction V, for example in each case by at least 1 um. Thus, the top side 10 is not flat but comprises raised sections attributed to the projecting regions. The contact regions 13 are in electrical contact with the main electrode 2, which is for example made of metal. The gate electrodes 3, which, in the first lateral direction L1, are in each case arranged between a contact region 13 and the drift region 14, are, for example, made of highly doped polysilicon. Each gate electrode 3 is assigned to a base region 12 and covers a channel portion 12a of the respective base region 12 in plan view of the top side 10. However, in this plan view the gate electrodes 3do not overlap the projecting drift region 14, i.e. are not aligned with the drift region in the first lateral direction L1.

The gate electrodes 3 are electrically isolated from the semiconductor body 1 by means of an electrically isolating material 5, which is, for example, SiO₂. The electrically isolating material 5 covers the gate electrode 3 on the side facing towards the semiconductor body 1, on the side facing away from the semiconductor body 1 and on the lateral surfaces running obliquely to the main extension plane of the semiconductor body 1. In the first lateral direction L1, the contact regions 13 as well as the drift region 14 adjoin the isolating material 5 covering the lateral surfaces of the gate electrodes 3. This is possible because the raised contact regions 13 and the raised drift region 14 are partially aligned with the gate electrode 3 in the vertical direction V.

As can be further seen in figure 1, the contact regions 13 project into the assigned base regions 12 such that the channel portions 12a of the base regions 12 are partially aligned with the contact regions 13 in the vertical direction V. The drift region 14 projects deeper into the semiconductor body 1 than the base regions 12, i.e. is, in vertical direction V, closer to the further main electrode 6.

The power semiconductor device 100 of figure 1 is a vertical MOSFET. The path of electrons during operation is indicated by the arrows. During operation and in the on state of the MOSFET, the channel portions 12a of the base regions 12 are partially depleted with help of the gate electrodes 3. This enables current, namely electrons, from flowing from the main electrodes 2 via the contact regions 13 and the depleted part of the channel portions 12a into the drift region 14 and from there through the drift layer 11 to the further main electrode 6. Due to the contact regions 13 projecting beyond the base regions 12, the contact resistance can be reduced. Since the projecting drift region 14 and the gate electrodes 3 are not aligned in lateral direction, the capacitance between the gate electrodes 3 and the further main electrode 6 is kept small. Since the contact regions 13 project into the base regions 12, electrons can be efficiently injected from the contact regions 13 into the depleted part of the channel portions 12a.

Figure 2 shows a second exemplary embodiment of the power semiconductor device 100 which is again a vertical power MOSFET. In this case, only one base region 12, one contact region 13 and one gate electrode 3 are shown. However, also in this case, there may be several base regions 12 and assigned contact regions 13 as well as several gate electrodes 3.

As one can guess from figure 2, the gate electrode 3 covers or overlaps, respectively, with the contact region 13 and the drift region 14 in plan view of the top side 10. Furthermore, a first section of the gate electrode 3 tapers in the direction towards the top side 10 and a second section tapers in direction away from the top side 10. Thus, in the cross-sectional view of figure 2, the gate electrode 3 is diamond shaped. Such a structure may be produced when the gate electrode 3 is formed after the contact regions 13 and/or after the drift region 14.

Figure 3 shows a third exemplary embodiment of the power semiconductor device 100, in which only the contact regions 13 project beyond the base regions 12 at the top side 10. The gate electrode 3 completely overlaps the drift region 14 in plan view of the top side 10.

Figure 4 shows a fourth exemplary embodiment of the power semiconductor device 100 in which, in contrast to the previous exemplary embodiments, the contact region 13 completely projects through the base region 12 and projects deeper into the semiconductor body 1 than the base region 12.

In all exemplary embodiments of the power semiconductor device 100 shown so far, the contact regions 13 and/or the drift regions 14 projecting beyond the base regions 12 may be grown epitaxially.

Figure 5 shows a flowchart of an exemplary embodiment of the method for producing a power semiconductor device. In a step S1, a semiconductor body with a top side is produced such that the semiconductor body has a drift layer of a first conductivity type, a base region of a second conductivity type vertically between the drift layer and the top side, a contact region of the first conductivity type vertically between the drift layer and the top side and adjoining the base region and the top side, and a drift region of the first conductivity type next to the base region in a first lateral direction and adjoining the base region. In a further step S2, a main electrode is applied on the top side and an electrical contact is established between the main electrode and the contact region. In a further step S3, a gate electrode is produced so that, in the end, the gate electrode is on the top side and next to the main electrode in the first lateral direction and so that, in plan view of the top side, the gate electrode at least partially overlaps a channel portion of the base region which lies, in the first lateral direction, between the contact region and the drift region. In step S1, the semiconductor body is produced such that, at the top side, at least one of the contact region and the drift region projects beyond the base region in vertical direction.

Figure 6 shows a position in an exemplary embodiment of the method for producing a power semiconductor device, for example the power semiconductor device 100 of figure 1. In this position, a base semiconductor body 1' is provided which is based, for example, on the same material system as the semiconductor body of figure 1. The base semiconductor body 1' comprises a substrate 15, an n-doped drift layer 11 and p-doped base regions 12 which adjoin a top side of the base semiconductor body 1'. The drift layer 11 and/or the base regions 12 may have been formed by the implantation of dopants. In order to produce laterally spaced base regions 12, a mask may have been used during the implantation.

In the next position, shown in figure 7, a gate electrode layer 30 is applied onto the top side of the base semiconductor body 1'. A layer of electrically isolating material 5 is arranged between the base semiconductor body 1' and the gate electrode layer 30.

In the position of figure 8, the gate electrode layer 30 has been structured so that individual gate electrodes 3 are produced which are spaced from each other in the first lateral direction L1. The gate electrodes 3 are electrically isolated from the base semiconductor body 1' by the electrically isolating material 5, which has been structured together with the gate electrode layer 30. For structuring the gate electrode layer 30 and the underlying electrically isolating material 5, an etching process using a mask may have been used.

In the position of figure 9, electrically isolating material 5 has been applied onto the lateral surfaces of the gate electrodes 3, these lateral surfaces run obliquely to the main extension plane of the base semiconductor body 1'. For depositing the electrically isolating material 5, a conformal or undirected deposition method may have been used. Electrically isolating material which was possibly deposited onto the top side of the semiconductor base body 1' has been removed.

In the position of figure 10, holes are etched into the base semiconductor body 1', namely in the areas where the contact regions and the drift regions are to be produced. In the areas of the contact regions to be produced, the etched holes do not completely project through the base regions 12 but open into the base regions 12. Alternatively, however, the holes in these areas may have been etch completely through the base regions 12. In the area of the to-be-produced drift region, the etched hole is deeper.

Figure 11 shows a position in which contact regions 13 and the drift regions 14 are selectively, epitaxially grown in the areas which have been etched before. The growth is performed such that the contact regions 13 and the drift region 14 finally project beyond the base regions 12 at the top side 10 in vertical direction V. For growing the contact regions 13 and the drift region 14, the gate electrodes 3 with the electrically isolating material 5 on the respective lateral surfaces may have been used as a mask for the selective growth process. The growth of the contact regions 13 and the drift region 14 has the advantage that the doping concentration of these regions can be independently adjusted and can be set to be greater than, for example, in an implantation process. In figure 11, the final position in the production of the semiconductor body 1 is shown.

Figure 12 shows a position in which a main electrode 2, e.g. of metal, is applied onto the top side 10 of the semiconductor body 1 and in which an electrical connection of the main electrode 2 to the contact regions 13 is established.

In order to finalize the power semiconductor device, a further main electrode may be applied to the back side of the semiconductor body 1 (see figure 1).

The embodiments shown in the Figures as stated represent exemplary embodiments of the improved power semiconductor device and the improved method for producing a power semiconductor device; therefore, they do not constitute a complete list of all embodiments according to the improved power semiconductor device and method as defined in the appended claims. Actual power semiconductor devices and methods may vary from the embodiments shown in terms of arrangements, elements, order of method steps, for example.

### Reference Signs

- 1: semiconductor body
- 1': base semiconductor body
- 2: main electrode
- 3: gate electrodes
- 5: electrically isolating material
- 6: further main electrode
- 10: top side
- 11: drift layer
- 12: base region
- 12a: channel portion
- 13: contact region
- 14: drift region
- 15: substrate
- 30: gate electrode layer
- 100: power semiconductor device
- L1: first lateral direction
- V: vertical direction
- Si: method step

## Claims

1. Power semiconductor device (100) comprising
- a semiconductor body (1) with a top side (10),
- a main electrode (2) on the top side (10) and
- a gate electrode (3) on the top of a base region and arranged next to the main electrode (2) in a first lateral direction (L1), wherein
- the semiconductor body (1) comprises
- a drift layer (11) of a first conductivity type,
- the base region (12) of a second conductivity type arranged vertically between the drift layer (11) and the top side (10),
- a contact region (13) of the first conductivity type at the top side (10) arranged vertically between the drift layer (11) and the top side (10), wherein the contact region (13) adjoins the base region (12),
- a drift region (14) of the first conductivity type arranged next to the base region (12) in the first lateral direction (L1) and adjoining the base region (12),
- the main electrode (2) is in electrical contact with the top of the contact region (13),
- in plan view of the top side (10), the gate electrode (3) at least partially covers a channel portion (12a) of the base region (12) which lies, in the first lateral direction (L1), between the contact region (13) and the drift region (14), **characterized in that**
- at the top side (10), the contact region (13) projects beyond the top of the base region (12) in vertical direction (V) .

2. Power semiconductor device (100) according to claim 1, wherein
- at least one of the contact region (13) and the drift region (14) is grown epitaxially.

3. Power semiconductor device (100) according to claim 2, wherein at least one of the epitaxially grown regions (13, 14) has
- an inverted doping profile with a doping concentration decreasing in a direction pointing from the interior of the semiconductor body (1) towards the top side (10) or
- a homogenous doping profile.

4. Power semiconductor device (100) according to any one of the preceding claims, wherein
- at the top side (10), the drift region (14) projects beyond the base region (12) in vertical direction (V),
- in plan view of the top side (10), the gate electrode (3) covers at most a portion of the drift region (14).

5. Power semiconductor device (100) according to any one of the preceding claims, wherein
- the contact region (13) and the channel portion (12a) at least partially overlap with each other when viewed along the first lateral direction (L1).

6. Power semiconductor device (100) according to any one of the preceding claims, wherein
- the drift region (14) has a greater doping concentration than the drift layer (11).

7. Power semiconductor device (100) according to any one of the preceding claims, wherein
- in plan view of the top side (10), the gate electrode (3) partially covers the contact region (13).

8. Power semiconductor device (100) according to any one of the preceding claims, wherein
- the power semiconductor device is a MOSFET or an IGBT or a MISFET.

9. Power semiconductor device (100) according to any one of the preceding claims, wherein
- the semiconductor body (1) is based on a wide-bandgap semiconductor.

10. Power semiconductor device (100) according to any one of the preceding claims, wherein
- the gate electrode (3) and at least one of the contact region (13) and the drift region (14) projecting beyond the base region (12) at least partially overlap with each other when viewed along the first lateral direction (L1).

11. Method for producing a power semiconductor device (100), comprising
- producing a semiconductor body (1) with a top side (10) such that the semiconductor body (1) has
- a drift layer (11) of a first conductivity type,
- a base region (12) of a second conductivity type arranged vertically between the drift layer (11) and the top side (10),
- a contact region (13) of the first conductivity type arranged vertically between the drift layer (11) and the top side (10) and adjoining the base region (12) and being located at the top side (10),
- a drift region (14) of the first conductivity type arranged next to the base region (12) in a first lateral direction (L1) and adjoining the base region (12),
- applying a main electrode (2) onto the top side (10) and establishing an electrical contact between the main electrode (2) and the contact region (13),
- producing a gate electrode (3) so that, in the end, the gate electrode (3) is arranged on the top of the base region (12) and next to the main electrode (2) in the first lateral direction (L1) and so that, in plan view of the top side (10), the gate electrode (3) overlaps at least a channel portion (12a) of the base region (12) which lies, in the first lateral direction (L1), between the contact region (13) and the drift region (14), wherein
- the semiconductor body (1) is produced such that, at the top side (10), the contact region (13) projects beyond the top of the base region (12) in vertical direction (V).

12. Method according to claim 11, wherein
- the production of the semiconductor body (1) comprises
- providing a base semiconductor body (1') having the drift layer (11) and the base region (12),
- epitaxially growing at least one of the contact region (13) and the drift region (14) on the base semiconductor body (1').

13. Method according to claim 12, wherein
- an inverted doping profile of the epitaxially grown region (13, 14) is created by reducing the mass flow of a doping precursor during the epitaxial growth done by Chemical Vapor Deposition.

14. Method according to claim 12 or 13, wherein
- before growing the contact region (13), a portion of the base semiconductor body (1') is removed in the area where the contact region (13) is to be formed,
- the contact region (13) is grown in that area.

15. Method according to any one of claims 12 to 14, wherein
- before growing the drift region (14), a portion of the base semiconductor body (1') is removed in the area where the drift region (14) is to be formed,
- the drift region (14) is grown in that area.

16. Method according to any one of claims 12 to 15, wherein
- the gate electrode (3) is formed on the base semiconductor body (1')
- an electrically isolating material (5) is applied at least on lateral surfaces of the gate electrode (3),
- at least one of the contact region (13) and the drift region (14) is selectively grown adjacent to the gate electrode (3) with the applied isolating material (5).

## Patentansprüche

1. Leistungshalbleiterbauelement (100), umfassend:
- einen Halbleiterkörper (1) mit einer Oberseite (10),
- eine Hauptelektrode (2) auf der Oberseite (10) und
- eine Gate-Elektrode (3) auf der Oberseite einer Basisregion und angeordnet neben der Hauptelektrode (2) in einer ersten Querrichtung (L1), wobei
- der Halbleiterkörper (1) umfasst:
- eine Driftschicht (11) eines ersten Leitfähigkeitstyps,
- die Basisregion (12) eines zweiten Leitfähigkeitstyps, die vertikal zwischen der Driftschicht (11) und der Oberseite (10) angeordnet ist,
- eine Kontaktregion (13) des ersten Leitfähigkeitstyps an der Oberseite (10), der vertikal zwischen der Driftschicht (11) und der Oberseite (10) angeordnet ist, wobei die Kontaktregion (13) an die Basisregion (12) angrenzt,
- eine Driftregion (14) des ersten Leitfähigkeitstyps, die neben der Basisregion (12) in der ersten Querrichtung (L1) angeordnet ist und an die Basisregion (12) angrenzt,
- die Hauptelektrode (2) in elektrischem Kontakt mit der Oberseite der Kontaktregion (13) steht,
- die Gate-Elektrode (3) in Draufsicht auf die Oberseite (10) einen Kanalabschnitt (12a) der Basisregion (12), die in der ersten Querrichtung (L1) zwischen der Kontaktregion (13) und der Driftregion (14) liegt, zumindest teilweise überdeckt, **dadurch gekennzeichnet, dass**
- auf der Oberseite (10) die Kontaktregion (13) in Vertikalrichtung (V) über die Oberseite der Basisregion (12) hinausragt.

2. Leistungshalbleiterbauelement (100) nach Anspruch 1, wobei
- mindestens eine der Kontaktregion (13) und der Driftregion (14) epitaxial aufgewachsen ist.

3. Leistungshalbleiterbauelement (100) nach Anspruch 2, wobei mindestens eine der epitaxial aufgewachsenen Regionen (13, 14) aufweist:
- ein invertiertes Dotierungsprofil mit einer in Richtung vom Inneren des Halbleiterkörpers (1) zur Oberseite (10) hin abnehmenden Dotierungskonzentration oder
- ein homogenes Dotierungsprofil.

4. Leistungshalbleiterbauelement (100) nach einem der vorhergehenden Ansprüche, wobei
- auf der Oberseite (10) die Driftregion (14) in Vertikalrichtung (V) über die Basisregion (12) hinausragt,
- in Draufsicht auf die Oberseite (10) die Gate-Elektrode (3) höchstens einen Abschnitt der Driftregion (14) überdeckt.

5. Leistungshalbleiterbauelement (100) nach einem der vorhergehenden Ansprüche, wobei
- die Kontaktregion (13) und der Kanalabschnitt (12a) sich bei Betrachtung entlang der ersten Querrichtung (L1) zumindest teilweise überlappen.

6. Leistungshalbleiterbauelement (100) nach einem der vorhergehenden Ansprüche, wobei
- die Driftregion (14) eine höhere Dotierungskonzentration als die Driftschicht (11) aufweist.

7. Leistungshalbleiterbauelement (100) nach einem der vorhergehenden Ansprüche, wobei
- in Draufsicht auf die Oberseite (10) die Gate-Elektrode (3) teilweise die Kontaktregion (13) überdeckt.

8. Leistungshalbleiterbauelement (100) nach einem der vorhergehenden Ansprüche, wobei
- das Leistungshalbleiterbauelement ein MOSFET oder ein IGBT oder ein MISFET ist.

9. Leistungshalbleiterbauelement (100) nach einem der vorhergehenden Ansprüche, wobei
- der Halbleiterkörper (1) auf einem Halbleiter mit breiter Bandlücke basiert.

10. Leistungshalbleiterbauelement (100) nach einem der vorhergehenden Ansprüche, wobei
- die Gate-Elektrode (3) und mindestens eine der Kontaktregion (13) und der Driftregion (14), die über die Basisregion (12) hinausragen, sich bei Betrachtung entlang der ersten Querrichtung (L1) zumindest teilweise gegenseitig überlappen.

11. Verfahren zur Herstellung eines Leistungshalbleiterbauelements (100), umfassend
- Herstellen eines Halbleiterkörpers (1) mit einer Oberseite (10), sodass der Halbleiterkörper (1) aufweist:
- eine Driftschicht (11) eines ersten Leitfähigkeitstyps,
- eine Basisregion (12) eines zweiten Leitfähigkeitstyps, die vertikal zwischen der Driftschicht (11) und der Oberseite (10) angeordnet ist,
- eine Kontaktregion (13) des ersten Leitfähigkeitstyps, die vertikal zwischen der Driftschicht (11) und der Oberseite (10) angeordnet ist und an die Basisregion (12) angrenzt und sich an der Oberseite (10) befindet,
- eine Driftregion (14) des ersten Leitfähigkeitstyps, die neben der Basisregion (12) in einer ersten Querrichtung (L1) angeordnet ist und an die Basisregion (12) angrenzt,
- Aufbringen einer Hauptelektrode (2) auf die Oberseite (10) und Herstellen eines elektrischen Kontakts zwischen der Hauptelektrode (2) und der Kontaktregion (13),
- Herstellen einer Gate-Elektrode (3), sodass die Gate-Elektrode (3) schließlich auf der Oberseite der Basisregion (12) und in der ersten Querrichtung (L1) neben der Hauptelektrode (2) angeordnet ist und sodass die Gate-Elektrode (3) in Draufsicht auf die Oberseite (10) mindestens einen Kanalabschnitt (12a) der Basisregion (12) überlappt, der in der ersten Querrichtung (L1) zwischen der Kontaktregion (13) und der Driftregion (14) liegt, wobei
- der Halbleiterkörper (1) so hergestellt wird, dass auf der Oberseite (10) die Kontaktregion (13) in Vertikalrichtung (V) über die Oberseite der Basisregion (12) hinausragt.

12. Verfahren nach Anspruch 11, wobei
- die Herstellung des Halbleiterkörpers (1) umfasst:
- Bereitstellen eines Basis-Halbleiterkörpers (1') mit der Driftschicht (11) und der Basisregion (12),
- epitaxiales Aufwachsen mindestens einer der Kontaktregion (13) und der Driftregion (14) auf dem Basis-Halbleiterkörper (11).

13. Verfahren nach Anspruch 12, wobei
- ein invertiertes Dotierungsprofil der epitaxial aufgewachsenen Region (13, 14) durch Verringerung des Massenstroms eines Dotierungsvorläufers während des epitaxialen Wachstums durch chemische Gasphasenabscheidung erzeugt wird.

14. Verfahren nach Anspruch 12 oder 13, wobei:
- vor dem Aufwachsen der Kontaktregion (13) ein Abschnitt des Basis-Halbleiterkörpers (1') in dem Bereich entfernt wird, in dem die Kontaktregion (13) gebildet werden soll,
- die Kontaktregion (13) in diesem Bereich aufgewachsen wird.

15. Verfahren nach einem der Ansprüche 12 bis 14, wobei
- vor dem Aufwachsen der Driftregion (14) ein Abschnitt des Basis-Halbleiterkörpers (1') in dem Bereich entfernt wird, in dem die Driftregion (14) gebildet werden soll,
- die Driftregion (14) in diesem Bereich aufgewachsen wird.

16. Verfahren nach einem der Ansprüche 12 bis 15, wobei
- die Gate-Elektrode (3) auf dem Basis-Halbleiterkörper (1') gebildet wird,
- ein elektrisch isolierendes Material (5) mindestens auf den Seitenflächen der Gate-Elektrode (3) aufgebracht wird,
- mindestens eine der Kontaktregion (13) und der Driftregion (14) selektiv angrenzend an die Gate-Elektrode (3) mit dem aufgebrachten isolierenden Material (5) aufgewachsen wird.

## Revendications

1. Dispositif à semi-conducteur de puissance (100) comprenant
- un corps semi-conducteur (1) avec un côté supérieur (10),
- une électrode principale (2) sur le côté supérieur (10) et
- une électrode de grille (3) sur le sommet d'une région de base et disposée à côté de l'électrode principale (2) dans une première direction latérale (L1), dans lequel
- le corps semi-conducteur (1) comprend
- une couche de dérive (11) d'un premier type de conductivité,
- la région de base (12) d'un second type de conductivité disposée verticalement entre la couche de dérive (11) et le côté supérieur (10),
- une région de contact (13) du premier type de conductivité sur le côté supérieur (10) disposée verticalement entre la couche de dérive (11) et le côté supérieur (10), dans lequel la région de contact (13) est adjacente à la région de base (12),
- une région de dérive (14) du premier type de conductivité disposée à côté de la région de base (12) dans la première direction latérale (L1) et adjacente à la région de base (12),
- l'électrode principale (2) est en contact électrique avec le sommet de la région de contact (13),
- en vue en plan du côté supérieur (10), l'électrode de grille (3) recouvre au moins en partie une partie de canal (12a) de la région de base (12) qui se trouve, dans la première direction latérale (L1), entre la région de contact (13) et la région de dérive (14), **caractérisé en ce que**
- sur le côté supérieur (10), la région de contact (13) se projette au-delà du sommet de la région de base (12) dans la direction verticale (V).

2. Dispositif à semi-conducteur de puissance (100) selon la revendication 1, dans lequel
- au moins l'une de la région de contact (13) et de la région de dérive (14) est soumise à une croissance épitaxiale.

3. Dispositif à semi-conducteur de puissance (100) selon la revendication 2, dans lequel au moins l'une des régions soumises à une croissance épitaxiale (13, 14) comprend
- un profil de dopage inverse avec une concentration de dopage diminuant dans une direction pointant de l'intérieur du corps semi-conducteur (1) vers le côté supérieur (10) ou
- un profil de dopage homogène.

4. Dispositif à semi-conducteur de puissance (100) selon l'une quelconque des revendications précédentes, dans lequel
- sur le côté supérieur (10), la région de dérive (14) se projette au-delà de la région de base (12) dans la direction verticale (V),
- en vue en plan du côté supérieur (10), l'électrode de grille (3) recouvre au plus une partie de la région de dérive (14) .

5. Dispositif à semi-conducteur de puissance (100) selon l'une quelconque des revendications précédentes, dans lequel
- la région de contact (13) et la partie de canal (12a) se chevauchent l'une l'autre au moins en partie, vues dans la première direction latérale (L1).

6. Dispositif à semi-conducteur de puissance (100) selon l'une quelconque des revendications précédentes, dans lequel
- la région de dérive (14) présente une plus grande concentration de dopage que la couche de dérive (11).

7. Dispositif à semi-conducteur de puissance (100) selon l'une quelconque des revendications précédentes, dans lequel
- en vue en plan du côté supérieur (10), l'électrode de grille (3) recouvre en partie la région de contact (13).

8. Dispositif à semi-conducteur de puissance (100) selon l'une quelconque des revendications précédentes, dans lequel
- le dispositif à semi-conducteur de puissance est un MOSFET ou un IGBT ou un MISFET.

9. Dispositif à semi-conducteur de puissance (100) selon l'une quelconque des revendications précédentes, dans lequel
- le corps semi-conducteur (1) est basé sur un semi-conducteur à large écart énergétique.

10. Dispositif à semi-conducteur de puissance (100) selon l'une quelconque des revendications précédentes, dans lequel
- l'électrode de grille (3) et au moins l'une de la région de contact (13) et de la région de dérive (14) se projetant au-delà de la région de base (12) se chevauchent l'une l'autre au moins en partie, vues dans la première direction latérale (L1).

11. Procédé de production d'un dispositif à semi-conducteur de puissance (100), comprenant
- la production d'un corps semi-conducteur (1) avec un côté supérieur (10) de telle sorte que le corps semi-conducteur (1) comprend
- une couche de dérive (11) d'un premier type de conductivité,
- une région de base (12) d'un second type de conductivité disposée verticalement entre la couche de dérive (11) et le côté supérieur (10),
- une région de contact (13) du premier type de conductivité disposée verticalement entre la couche de dérive (11) et le côté supérieur (10) et adjacente à la région de base (12) et située sur le côté supérieur (10),
- une région de dérive (14) du premier type de conductivité disposée à côté de la région de base (12) dans une première direction latérale (L1) et adjacente à la région de base (12),
- l'application d'une électrode principale (2) sur le côté supérieur (10) et l'établissement d'un contact électrique entre l'électrode principale (2) et la région de contact (13),
- la production d'une électrode de grille (3) de sorte que, à la fin, l'électrode de grille (3) soit disposée au sommet de la région de base (12) et à côté de l'électrode principale (2) dans la première direction latérale (L1) et de sorte que, en vue en plan du côté supérieur (10), l'électrode de grille (3) chevauche au moins en partie une partie de canal (12a) de la région de base (12) qui se trouve, dans la première direction latérale (L1), entre la région de contact (13) et la région de dérive (14), dans lequel
- le corps semi-conducteur (1) est produit de sorte que, sur le côté supérieur (10), la région de contact (13) se projette au-delà du sommet de la région de base (12) dans la direction verticale (V).

12. Procédé selon la revendication 11, dans lequel
- la production du corps semi-conducteur (1) comprend
- la fourniture d'un corps semi-conducteur de base (1') ayant la couche de dérive (11) et la région de base (12),
- la croissance épitaxiale d'au moins l'une de la région de contact (13) et de la région de dérive (14) sur le corps semi-conducteur de base (1') .

13. Procédé selon la revendication 12, dans lequel
- un profil de dopage inverse de la région soumise à une croissance épitaxiale (13, 14) est créé par la réduction du débit d'un précurseur de dopage pendant la croissance épitaxiale effectuée par dépôt chimique en phase vapeur.

14. Procédé selon la revendication 12 ou 13, dans lequel
- avant la croissance de la région de contact (13), une partie du corps semi-conducteur de base (1') est retirée dans la zone où la région de contact (13) doit être formée,
- la région de contact (13) est soumise à une croissance dans cette zone.

15. Procédé selon l'une quelconque des revendications 12 à 14, dans lequel
- avant la croissance de la région de dérive (14), une partie du corps semi-conducteur de base (1') est retirée dans la zone où la région de dérive (14) doit être formée,
- la région de dérive (14) est soumise à une croissance dans cette zone.

16. Procédé selon l'une quelconque des revendications 12 à 15, dans lequel
- l'électrode de grille (3) est formée sur le corps semi-conducteur de base (1')
- un matériau électriquement isolant (5) est appliqué au moins sur des surfaces latérales de l'électrode de grille (3),
- au moins l'une de la région de contact (13) et de la région de dérive (14) est soumise à une croissance de façon sélective et adjacente à l'électrode de grille (3) avec le matériau isolant appliqué (5).
